(19) Europäisches Patentamt

European Patent Office

Office européen des brevets

(11) **EP 4 708 602 A1**

(12) **EUROPEAN PATENT APPLICATION**

(43) Date of publication:
**11.03.2026 Bulletin 2026/11**

(21) Application number: **25306218.6**

(22) Date of filing: **28.07.2025**

(51) International Patent Classification (IPC):
**H02H 5/04** (2006.01)    **H02H 7/22** (2006.01)

(52) Cooperative Patent Classification (CPC):
**H02H 5/042;** H02H 7/008; H02H 7/222;
H03K 2017/0806

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **23.08.2024 CN 202422063792 U**

(71) Applicant: **SCHNEIDER ELECTRIC INDUSTRIES
SAS
92500 Rueil-Malmaison (FR)**

(72) Inventors:
• **LI, Heling**
**Shanghai, 201203 (CN)**

• **WANG, Han**
**Shanghai, 201203 (CN)**
• **DING, Yihan**
**Shanghai, 201203 (CN)**
• **HUANG, Zhili**
**Shanghai, 201203 (CN)**
• **JIAO, Xuyang**
**Shanghai, 201203 (CN)**
• **LIU, Jiawei**
**Shanghai, 201203 (CN)**
• **TIAN, Simon**
**Shanghai, 201203 (CN)**

(74) Representative: **Manitz Finsterwald
Patent- und Rechtsanwaltspartnerschaft mbB
Martin-Greif-Straße 1
80336 München (DE)**

(54) **SOLID-STATE CIRCUIT BREAKER WITH NEGATIVE TEMPERATURE COEFFICIENT TEMPERATURE DATA ACQUISITION**

(57) The disclosure relates to a solid-state circuit breaker with negative temperature coefficient NTC temperature data acquisition, wherein the solid-state circuit breaker includes: a plurality of first NTC temperature data acquisition circuits, each connected with an input end and an output end of power supply terminals and configured to acquire a first resistance value indicating temperature data of the power supply terminals; a plurality of second NTC temperature data acquisition circuits, each connected to both ends of a switch and configured to acquire a second resistance value indicating tempera-ture data of the switch; a voltage follower, configured to output a voltage value corresponding to the second resistance value; a voltage/frequency V/F conversion circuit, configured to output an amplitude-frequency converted voltage value; an isolator, configured to output a digitally isolated voltage value; and a microcontroller MCU, connected to the first NTC temperature data acquisition circuit and the isolator, and performs on-off of the switch based on the first resistance value and the digitally isolated voltage value.

Fig. 2

EP 4 708 602 A1

# Description

## CROSS-REFERENCE TO RELATED APPLICATION

This application is based on and claims priority to Chinese Patent Application No. 202422063792.9, filed on August 23, 2024 in the Chinese Patent Office, the contents of which being herein incorporated by reference in its entirety.

## TECHNICAL FIELD

The disclosure relates to an electrical device, in particular to a solid-state circuit breaker with Negative Temperature Coefficient (NTC) temperature data acquisition.

## BACKGROUND

Circuit breakers are widely used in power grid systems to be automatically turned off when there are faults in the circuit, such as short circuit and leakage that may cause personal and property safety, so that the load circuit is cut off and accidents are avoided. With the rapid development of power technology, the traditional mechanical circuit breaker is gradually unable to meet the increasingly high requirements of power system. Solid-state circuit breakers use power electronic devices as switching elements, which realize contactless switching operation, have fast response ability, can cut off fault current in a very short time, and effectively protect the system from short circuit, leakage and other faults.

Negative Temperature Coefficient (NTC) refers to thermistor phenomena and materials with negative temperature coefficient whose resistance decreases exponentially with the increase of temperature, generally referring to semiconductor materials or elements with large negative temperature coefficient. NTC thermistor is negative temperature coefficient thermistor. NTC has the advantages of low cost, simple peripheral design, etc. Therefore, NTC temperature data acquisition circuits are often installed in various products currently on the market to realize the temperature acquisition function. By measuring the resistance value of NTC sensor, the corresponding temperature can be determined. Based on this characteristic, by checking whether the temperature in the circuit or equipment is within the normal range, whether there are abnormal working states such as poor contact in the detected circuit or equipment can be determined, and the working states of the circuit or equipment can be controlled based on its working states.

## SUMMARY

The disclosure provides a solid-state circuit breaker with negative temperature coefficient NTC temperature data acquisition, wherein the solid-state circuit breaker comprises: a plurality of first NTC temperature data acquisition circuits, each of the plurality of first NTC temperature data acquisition circuits is connected with an input end and an output end of power supply terminals and is configured to acquire a first resistance value indicating temperature data of the power supply terminals; a plurality of second NTC temperature data acquisition circuits, each of the plurality of second NTC temperature data acquisition circuits is connected to both ends of switches and is configured to acquire a second resistance value indicating temperature data of the switches; a voltage follower, the input end of the voltage follower is connected with the second NTC temperature data acquisition circuit and the voltage follower is configured to output a voltage value corresponding to the second resistance value; a voltage/frequency V/F conversion circuit, an input end of the V/F conversion circuit is connected with an output end of the voltage follower, and the V/F conversion circuit is configured to output an amplitude-frequency converted voltage value; an isolator, an input end of the isolator is connected with an output end of the V/F conversion circuit, the isolator is configured to output a digitally isolated voltage value; and a microcontroller MCU, connected to the first NTC temperature data acquisition circuit and the isolator, and performs on-off of the switches based on the first resistance value and the digitally isolated voltage value.

According to the embodiment of the disclosure, wherein the power supply terminals comprise three-phase A, B and C terminals and an N terminal.

According to the embodiment of the disclosure, wherein the switches are metal oxide semiconductor field effect transistor MOSFET.

According to the embodiment of the disclosure, wherein the switches control the on-off of three-phase lines A, B and C.

According to the embodiment of the disclosure, wherein a number of the first NTC temperature data acquisition circuits is eight, and the eight first NTC temperature data acquisition circuits are configured to acquire eight channels of temperature data of the power supply terminals, respectively.

According to the embodiment of the disclosure, wherein a number of the second NTC temperature data acquisition circuits is six, and the six second NTC temperature data acquisition circuits are configured to acquire six channels of temperature data of the switches, respectively.

According to the embodiment of the disclosure, wherein the first resistance value is input to the analog to digital converter ADC port of the MCU through input/output I/O expansion.

According to the embodiment of the disclosure, wherein the I/O extension receives an address signal through the I/O port of the MCU, and selects a first resistance value to be input to the ADC port of the MCU based on the received address signal.

According to the embodiment of the disclosure, wherein the digitally isolated voltage value corresponding to the second resistance value is input to the I/O port of the MCU.

According to the embodiment of the disclosure, wherein the voltage follower is further configured to isolate the second resistance value from the back-end circuit.

In this disclosure, the proposed solid-state circuit breaker with NTC temperature data acquisition can acquire the temperature of key points for the main circuit from A, B, C and N terminals to MOSFET, so as to determine the contact state of the main circuit, and turn on or turn off the switch based on the determination that whether the contact is good or not, realizing the on-off of the main circuit.

BRIEF DESCRIPTION OF DRAWINGS

The above and other aspects, features and advantages of specific embodiments of the disclosure will become more apparent from the following description taken in conjunction with the accompanying drawings, in which:

  Fig. 1 is a schematic structural diagram showing a solid-state circuit breaker provided in an embodiment of the disclosure;
  Fig. 2 is a schematic block diagram showing a solid-state circuit breaker provided in an embodiment of the disclosure;
  Fig. 3 is a schematic diagram showing a V/F conversion circuit provided in an embodiment of the disclosure;
  Fig. 4 is a schematic block diagram showing a system including the solid-state circuit breaker provided in an embodiment of the disclosure.

DETAILED DESCRIPTION

Before the following detailed description, it may be beneficial to explain the definitions of some words and phrases used throughout the disclosure. The terms "including" and "containing" and their derivatives refer to including but not limited to. The term "controller" or "control unit" refers to any device, system or part thereof that controls at least one operation. Such a controller may be implemented in hardware or a combination of hardware and software and/or firmware. For example, the controller may include, for example, an application specific integrated circuit (ASIC), a general or special central processing unit (CPU), a digital signal processor (DSP), and a programmable logic device such as a field programmable gate array (FPGA). The controller can be manufactured as a single printed circuit board (PCB) or distributed on several interconnected PCBs. The controller may include other processing circuits. For example, the controller may include two processing circuits such as an FPGA and a CPU connected to each other on a PCB. The functions associated with any particular controller can be centralized or distributed, whether local or remote. The phrase "at least one", when used with a list of items, means that different combinations of one or more of the listed items can be used, and only one item in the list may be needed. For example, "at least one of a, b and c" includes any one of the following combinations: A, B, C, A and B, A and C, B and C, A and B and C. At the same time, in the description of the disclosure, the terms "first" and "second" are only used to distinguish descriptions, and cannot be understood as indicating or implying relative importance or ordering. In the embodiment of the present disclosure, unless otherwise specified, "connected" does not necessarily mean "directly connected" or "directly contacted", but only needs to be electrically connected.

Definitions of other specific words and phrases are provided throughout this disclosure. It should be understood by those skilled in the art that in many cases, if not most cases, such definitions also apply to the previous and future uses of words and phrases so defined.

The following description of various embodiments of the principles of the present disclosure in this patent application document taken in conjunction with the accompanying drawings is for illustration only and should not be interpreted as limiting the scope of the present disclosure in any way. Those skilled in the art will understand that the principles of the present disclosure can be implemented in any suitably arranged system or device. In some cases, the actions described in the specification can be performed in a different order and still achieve the desired results. Moreover, the processes depicted in the drawings do not necessarily require the specific order or sequential order shown to achieve the desired results. In certain embodiments, multitasking and parallel processing may be advantageous.

The text and drawings are provided as examples only to help understand the present disclosure. They should not be construed as limiting the scope of the claims appended to this disclosure in any way. Throughout the drawings, like reference numerals generally indicate like elements. Although certain embodiments and examples have been provided, based on the disclosure, it is clear to those skilled in the art that changes can be made to the illustrated embodiments and examples without departing from the scope of the disclosure.

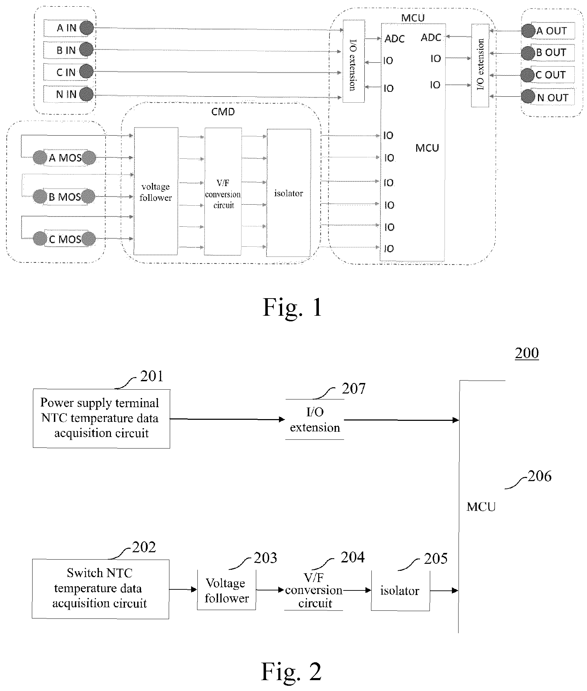

Fig. 1 is a schematic structural diagram showing a solid-state circuit breaker provided in an embodiment of the disclosure.

Referring to Fig. 1, a solid-state circuit breaker may include a plurality of first NTC temperature data acquisition circuits, a plurality of second NTC temperature data acquisition circuits, a voltage follower, a voltage/frequency V/F conversion circuit, an isolator, and a microprocessor.

Each of a plurality of first NTC temperature data acquisition circuits may be connected to the input ends and the output ends of power supply terminals, wherein the power supply terminals may include three-phase A, B and C terminals and an N terminal. A, B, C and N respectively represent the three phases A, B and C in the three-phase four-wire transmission line, and the neutral line N. Generally, three-phase four-wire system refers to the connection mode composed of three live wires and one neutral wire, and the circuit powered by three-phase power supply is called three-phase circuit. In a three-phase system, when the three phases are balanced, no current flows in the neutral line (zero line).

Each of a plurality of second NTC temperature data acquisition circuits may be connected to both ends of switches. In the embodiment of the disclosure, the switches may be metal oxide semiconductor field effect transistor MOSFET. Wherein, the switches may control the on-off of three-phase lines A, B and C.

The input ends of the voltage follower may be connected with a second NTC temperature data acquisition circuit.

The input ends of the voltage/frequency V/F conversion circuit may be connected to the output end of the voltage follower.

The input ends of the isolator may be connected to the output end of the V/F conversion circuit, and the output end of the isolator is connected to the microprocessor.

The microprocessor may be implemented with MCU, and the microprocessor may occupy four I/O ports and two ADC ports to receive the acquired temperature data of A, B, C and N terminals through I/O expansion, and the microprocessor may occupy six I/O ports to receive the acquired temperature data of MOSFET.

Fig. 2 is a schematic block diagram showing a solid-state circuit breaker provided in an embodiment of the disclosure.

Referring to Fig. 2, the solid-state circuit breaker 200 may include power supply terminal NTC temperature data acquisition circuit 201, a switch NTC temperature data acquisition circuit 202, a voltage follower 203, a voltage/frequency V/F conversion circuit 204, an isolator 205 and an MCU 206.

The power supply terminal NTC temperature data acquisition circuit 201 may be a first NTC temperature data acquisition circuit and may be configured to acquire a first resistance value indicating the temperature data of the power supply terminals. Wherein, the power supply terminals may include three-phase A, B and C terminals and N terminals. After insulation processing such as insulation glue attachment is performed, the first resistance value indicating the temperature data of the input ends and output ends of the A, B, C and N terminals may be transmitted to the MCU 206.

Wherein, the acquired first resistance value indicating the temperature data of the input ends and output ends of A, B, C and N terminals may be input to the ADC port of MCU through I/O expansion 207. The I/O extension 207 receives the address signal through the I/O port of the MCU, and selects the first resistance value to be input to the ADC port of the MCU based on the received address signal, thus implementing the acquisition of temperature data. By acquiring 8 channels of temperature data of A, B, C and N terminals, whether there is abnormal temperature rise of terminals due to poor contact may be determined, such that the main circuit may be break in case of abnormal heat. In the embodiment of the disclosure, the main loop can represent the loop from the A, B, C and N terminals to the MOSFET in the solid-state circuit breaker 200.

In addition, in the solid-state circuit breaker of the disclosure, when acquiring the 8 channels of temperature data of A, B, C and N terminals, the temperature data acquisition may be implemented by occupying four I/O ports and two ADCs of the MCU after chip selection of the 8 channels of temperature data of A, B, C and N terminals, thus saving the resources of the MCU.

The switch NTC temperature data acquisition circuit 202 may be a second NTC temperature data acquisition circuit and may be configured to acquire a second resistance value indicating the temperature data of the switches. Wherein, the switches may be metal oxide semiconductor field effect transistor MOSFET, and may control the on-off of three-phase A, B and C lines. After data processing including amplitude-frequency conversion and digital isolation, the temperature data of MOSFET may be converted into digital signals that meet the insulation requirements, and then may be transmitted to 6 I/O ports of MCU 206 to implement the acquisition of temperature data.

By acquiring 6 channels of MOSFET temperature data with the switch NTC temperature data acquisition circuit, the real-time detection of MOSFET temperature may be implemented, so that the MCU may receive the fault information and turn off the circuit when there is overtemperature.

In data processing including amplitude-frequency conversion, digital isolation, etc. for the second resistance value indicating the temperature data of the switches, the voltage follower 203 may be used to prevent the resistance value obtained by voltage division from being influenced by the back-end circuit. In the voltage follower, the second resistance value indicating the temperature data of the switches acquired by the switch NTC temperature data acquisition circuit may be calculated according to the following equation 1:

$$[\text{Equation 1}]$$

$$V(T) = 5\,\text{V} \cdot \frac{R(T)}{10\,k\Omega + R(T)}$$

Wherein, R(T) is the resistance value acquired by the MOSFET NTC temperature data acquisition circuit, V(T) is the output voltage value of the voltage follower, and the output voltage value corresponds to the second resistance value. Because the resistance of NTC decreases exponentially with the increase of temperature, the internal resistance value of NTC is in the range of 334,280 Ω ~ 181.41 Ω corresponding to the temperature range of -40 °C~150 °C.

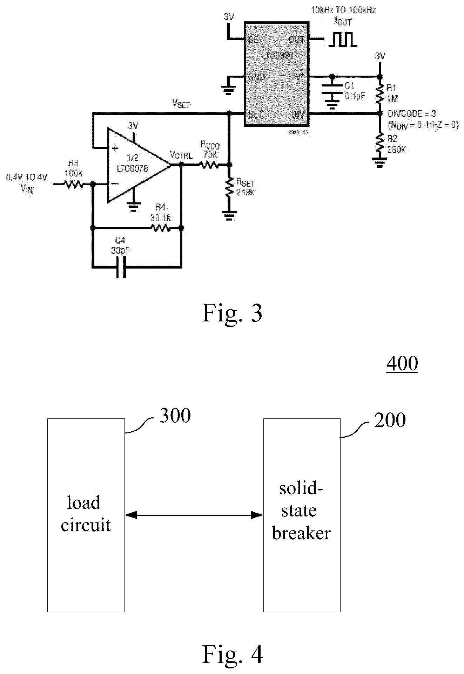

The V/F conversion circuit 204 may be used to perform amplitude-frequency conversion on the voltage value corresponding to the second resistance value output by the voltage follower, and output the amplitude-frequency converted voltage value. The specific method of calculating the frequency output may be shown with reference to Fig. 3.

The isolator 205 can be used to digitally isolate the amplitude-frequency converted voltage value and output the digitally isolated voltage value.

The MCU 206 may be used to receive the acquired temperature data. Based on the received and acquired first resistance value corresponding to the temperature data of the power supply terminals and the digitally isolated voltage value corresponding to the temperature data of the switches, MCU 206 may determine the working states of the main circuit and control the on-off of the main circuit. For example, based on the acquired temperature data, MCU 206 may determine whether there is a phenomenon of overtemperature caused by poor contact and excessive local current in the main loop caused by impurities, and then perform the on-off of the switches to control the on-off of the main loop.

The solid-state circuit breaker provided by the disclosure has a compact structure, and there are physical location restrictions when designing the NTC temperature data acquisition of A, B, C and N terminals and the NTC temperature data acquisition of MOSFET. Therefore, when acquiring 8 channels of A, B, C and N terminal temperature data and 6 channels of MOSFET temperature data, it is necessary to classify the acquisition positions. Due to the structural design of the solid-state circuit breaker, the acquisition loop is as short as possible. For two kinds of temperature acquisition circuits for the A, B, C, N terminals and MOSFET, insulation treatments are carried out in different ways.

Fig. 3 is a schematic diagram showing a V/F conversion circuit provided in an embodiment of the disclosure.

Referring to Fig. 3, the V/F conversion circuit provided by the embodiment of the disclosure includes a precision silicon oscillator LTC6990 which may be used as a fixed frequency or voltage-controlled oscillator.

Referring to Fig. 3, in the V/F conversion circuit provided by the embodiment of this disclosure, the frequency output may be calculated according to the following Equation 2:

[Equation 2]

$$f(T) = \frac{1\,MHz}{Ndiv} \cdot \frac{50\,k\Omega}{Rvco} \cdot \left( \frac{Rvco}{Rset} + \left( \frac{V(T)}{Vset} - 1 \right) \cdot \frac{Rf}{Rg} \right)$$

Where, V(T) is the output voltage value of the voltage follower, $f(T)$ is the frequency output of the V/F conversion circuit. For the temperature in the range of -40 °C ~150 °C , the frequency output is in the range of 14.641kHz~1.37kHz. Ndiv is the internal divider value and is set to Ndiv = 64; the control voltage changes the current Iset by supplying/absorbing the current with Rvco, and Rvco is set as the first reference resistance Rvco = 62 kΩ; a single resistor Rset programs the internal master oscillator frequency of LTC6990 and is sets as the second reference resistor Rset = 200 kΩ; Vset is the voltage of the SET pin of LTC6990 and is set as Vset = 1 V; a third reference resistor Rg = 10 kΩ; a fourth reference resistance Rf = 2.21 kΩ.

Fig. 4 is a schematic block diagram showing a system including a solid-state circuit breaker provided in an embodiment of the disclosure.

Referring to Fig. 4, the system 400 includes a solid-state circuit breaker 200 and a load circuit 300. Wherein, the solid-state circuit breaker 200 is connected to the load circuit 300, so as to be turned off in the case of short circuit, leakage and other faults that may cause personal and property safety, thus the load circuit 300 may be powered off.

As described above, the solid-state circuit breaker 200 is a solid-state circuit breaker with negative temperature coefficient NTC temperature data acquisition, wherein the solid-state circuit breaker comprises: a plurality of first NTC temperature data acquisition circuits, each of the plurality of first NTC temperature data acquisition circuits is connected with an input end and an output end of power supply terminals and is configured to acquire a first resistance value indicating temperature data of the power supply terminals; a plurality of second NTC temperature data acquisition circuits, each of the plurality of second NTC temperature data acquisition circuits is connected to both ends of switches and is configured to acquire a second resistance value indicating temperature data of the switches; a voltage follower, the input end of the voltage follower is connected with the second NTC temperature data acquisition circuit and the voltage follower is configured to output a voltage value corresponding to the second resistance value; a voltage/frequency V/F conversion circuit, an input end of the V/F conversion circuit is connected with an output end of the voltage follower, and the V/F conversion circuit is configured to output an amplitude-frequency converted voltage value; an isolator, an input end of the isolator is connected with an output end of the V/F conversion circuit, the isolator is configured to output a digitally isolated voltage value; and a microcontroller MCU, connected to the first NTC temperature data acquisition circuit and the isolator, and performs on-off of the switches based on the first resistance value and the digitally isolated voltage value.

Although the disclosure has been described with exemplary embodiments, various changes and modifications can be suggested to those skilled in the art. The disclosure intends to cover such changes and modifications that fall within the scope of the appended claims.

Any description in this disclosure should not be understood as implying that any specific element, step or function is an essential element that must be included in the scope of the claims. The scope of the patent subject matter is limited only by the claims.

## Claims

1. A solid-state circuit breaker (200) with negative temperature coefficient NTC temperature data acquisition, wherein the solid-state circuit breaker (200) comprises:

   a plurality of first NTC temperature data acquisition circuits, each of the plurality of first NTC temperature data acquisition circuits is connected with an input end and an output end of power supply terminals and is configured to acquire a first resistance value indicating temperature data of the power supply terminals;
   a plurality of second NTC temperature data acquisition circuits, each of the plurality of second NTC temperature data acquisition circuits is connected to both ends of switches and is configured to acquire a second resistance value indicating temperature data of the switches;
   a voltage follower (203), the input end of the voltage follower (203) is connected with the second NTC temperature data acquisition circuit and the voltage follower (203) is configured to output a voltage value corresponding to the second resistance value;
   a voltage/frequency V/F conversion circuit (204), an input end of the V/F conversion circuit (204) is connected with an output end of the voltage follower (203), and the V/F conversion circuit (204) is configured to output an amplitude-frequency converted voltage value;
   an isolator (205), an input end of the isolator (205) is connected with an output end of the V/F conversion circuit (204), the isolator (205) is configured to output a digitally isolated voltage value; and
   a microcontroller MCU (206), connected to the first NTC temperature data acquisition circuit and the isolator (205), and performs on-off of the switches based on the first resistance value and the digitally isolated voltage value.

2. The solid-state circuit breaker (200) of claim 1, wherein the power supply terminals comprise three-phase A, B and C terminals and an N terminal.

3. The solid-state circuit breaker (200) of claim 1, wherein the switches are metal oxide semiconductor field effect transistor MOSFET.

4. The solid-state circuit breaker (200) of claim 1, wherein the switches control the on-off of three-phase lines A, B and C.

5. The solid-state circuit breaker (200) of claim 1, wherein a number of the first NTC temperature data acquisition circuits is eight, and the eight first NTC temperature data acquisition circuits are configured to acquire eight channels of temperature data of the power supply terminals, respectively.

6. The solid-state circuit breaker (200) of claim 1, wherein a number of the second NTC temperature data acquisition circuits is six, and the six second NTC temperature data acquisition circuits are configured to acquire six channels of temperature data of the switches, respectively.

7. The solid-state circuit breaker (200) of claim 1, wherein the first resistance value is input to the analog to digital converter ADC port of the MCU (206) through input/output I/O expansion.

8. The solid-state circuit breaker (200) of claim 7, wherein the I/O extension receives an address signal through the I/O port of the MCU (206), and selects a first resistance value to be input to the ADC port of the MCU (206) based on the received address signal.

9. The solid-state circuit breaker (200) of claim 1, wherein the digitally isolated voltage value corresponding to the second resistance value is input to the I/O port of the MCU (206).

10. The solid-state circuit breaker (200) of claim 1, wherein the voltage follower (203) is further configured to isolate the second resistance value from the back-end circuit.

Fig. 1

Fig. 2

Fig. 3

400

Fig. 4

## EUROPEAN SEARCH REPORT

**Application Number**

**EP 25 30 6218**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2024/223177 A1 (CHEN JIANGANG [CN] ET AL) 4 July 2024 (2024-07-04) <br> * abstract * <br> * figures 1-2 * <br> * paragraph [0019] * <br> * paragraph [0033] - paragraph [0039] * <br> ----- | 1-10 | INV. <br> H02H5/04 <br><br> ADD. <br> H02H7/22 |
| Y | US 2009/167537 A1 (FELISS NORBERT A [US] ET AL) 2 July 2009 (2009-07-02) <br> * abstract * <br> * figures 1-2, 5 * <br> * paragraph [0026] - paragraph [0031] * <br> ----- | 1-10 | |
| A | US 2019/097416 A1 (SCHMALZ STEVEN CHRISTOPHER [US] ET AL) 28 March 2019 (2019-03-28) <br> * abstract * <br> * figures 1,4 * <br> * paragraph [0023] - paragraph [0028] * <br> ----- | 1-10 | |
| A | WO 2005/027326 A1 (SANKEN ELECTRIC CO LTD [JP]; IWABUCHI AKIO [JP]; AOKI HIRONORI [JP]) 24 March 2005 (2005-03-24) <br> * abstract * <br> * figures 1,3 * <br> * paragraph [0017] - paragraph [0022] * <br> ----- | 1-10 | **TECHNICAL FIELDS SEARCHED (IPC)** <br><br> H02H |

The present search report has been drawn up for all claims

| Place of search | Date of completion of the search | Examiner |
|---|---|---|
| Munich | 16 January 2026 | Operti, Antonio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 4 708 602 A1

## ANNEX TO THE EUROPEAN SEARCH REPORT
## ON EUROPEAN PATENT APPLICATION NO.

EP 25 30 6218

16-01-2026

| Patent document cited in search report | | Publication date | Patent family member(s) | | Publication date |
|---|---|---|---|---|---|
| US 2024223177 | A1 | 04-07-2024 | CN | 115985706 A | 18-04-2023 |
| | | | EP | 4328947 A1 | 28-02-2024 |
| | | | US | 2024223177 A1 | 04-07-2024 |
| | | | WO | 2023061270 A1 | 20-04-2023 |
| US 2009167537 | A1 | 02-07-2009 | NONE | | |
| US 2019097416 | A1 | 28-03-2019 | CA | 3018489 A1 | 27-03-2019 |
| | | | US | 2019097416 A1 | 28-03-2019 |
| WO 2005027326 | A1 | 24-03-2005 | JP | 2006352931 A | 28-12-2006 |
| | | | WO | 2005027326 A1 | 24-03-2005 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202422063792